# EUROPÄISCHE PATENTSCHRIFT

(11) **EP 0 201 453 B1**
(45) Veröffentlichungstag und Bekanntmachung des Hinweises auf die Patenterteilung: **11.08.1993**
(21) Anmeldenummer: 86730080.8
(22) Anmeldetag: 09.05.1986
(51) Int. Cl.: H01G 9/20, H01L 31/032, H01L 31/18, H01M 14/00

(54) **Solarzellen auf der Basis von CuInS2 und Verfahren zu deren Herstellung**
Solar cells on the basis of CuInS2 and method for making them
Cellules solaires à base de CuInS2 et leur procédé de fabrication

(30) Priorität: 10.05.1985 DE 3517464; 10.10.1985 DE 3536413
(43) Veröffentlichungstag der Anmeldung: 12.11.1986
(73) Patentinhaber: Hahn-Meitner-Institut Berlin Gesellschaft mit beschränkter Haftung, D-14109 Berlin (DE)
(72) Erfinder: Goslowsky, Hans, Dr., D-1000 Berlin 19 (DE); Lewerenz, Hans-Joachim, Dr. rer. nat., D-1000 Berlin 39 (DE); Fiechter, Manuel, Dr. rer. nat., D-1000 Berlin 37 (DE); Husemann, Karl-Dieter, Dipl.-Phys., D-1000 Berlin 42 (DE)
(74) Vertreter: Wolff, Konrad

(56) Entgegenhaltungen:
- EP-A- 0 136 967
- US-A- 4 559 282
- JOURNAL OF THE ELECTROCHEMICAL SOCIETY, Band 132, Nr. 7, July 1985, Seiten 1741-1745, Manchester, New Hampshire, US; M.A. RUSSAK et al.: "N-CulnS2/Sulfide-polysulfide elecrochemical photovoltaic cells"
- JOURNAL OF THE ELECTROCHEMICAL SOCIETY, Band 132, Nr. 5, Mai 1985, Seiten 1062-1070, Manchester, New Hampshire, US; D. CAHEN et al.: "Ternary chalcogenide-based photoelectrochemical cells"
- JOURNAL OF THE ELEKTROCHEMICAL SOCIETY, Band 125, Nr. 5, Mai 1978, Seiten 831-832; M. ROBBINS et al.: "CulnS2 liquid junction solar cells"

## Beschreibung

Die Erfindung bezieht sich auf Solarzellen mit einem Halbleitermaterial auf der Basis des CuInS₂-Materialsystems, sowie auf Verfahren zu deren Herstellung.

Dabei wird von dem aus der EP - A - 0 136 967 bekannten Stand der Technik ausgegangen, der sich besonders mit photoelektrochemischen Solarzellen befaßt, bei denen eine Arbeitselektrode eingesetzt wird, die mit einer Halbleiterschicht aus einem Material aufgebaut ist, das die ternären Verbindungen der Materialsysteme CuInSe₂ oder CuInS₂, einschließlich der Homogenitätsbereiche und in-situ erzeugter Oberflächenmodifizierungen dieser Verbindungen, umfaßt. Detaillierte Angaben finden sich bei diesem vorbekannten Stand der Technik allerdings nur bezüglich CuInSe₂-Material. Wesentlich sind die optimalen Eigenschaften hinsichtlich der Photoaktivität, die auf der Erzeugung einer Halbleiter-/Film-Struktur durch Umwandlungen an der Oberfläche des Halbleiters beruhen (vgl. a.a.O., Seite 5, Zeile 10 bis Seite 6, Zeile 15).

Im Zusammenhang mit weiterführenden Arbeiten auf diesem Gebiet hat sich überraschend gezeigt, daß ein Material auf CuInS₂-Basis, bei dem im Gegensatz zu hochreinem CuInSe₂-Material in gezielter Weise Fremdphasen zugelassen werden, zu einem noch höheren Wirkungsgrad, nämlich etwa 12,5 %, für die Umwandlung von Lichtenergie in elektrische Energie führt.

Es ist auch seit mehreren Jahren bekannt, Solarzellen mit Halbleiter-Heteroverbindungen aufzubauen (vgl. z.B.: "Thin Solid Films" 102(1983) - Electronics and Optics - Seiten 1 bis 46, insbesondere Seiten 33/34). Dabei werden insbesondere auch Paarungen von einem lichtdurchlässigen, halbleitenden Metalloxid mit großer Bandlücke und einem aktiven Halbleiter mit wesentlich geringerer Bandlücke angewendet, d.h. Strukturen vom Typ SIS (Semiconductor/Insulator/Semiconductor) gebildet.

Im Hinblick auf die oben erwähnten, als besonders aussichtsreich erscheinenden Ergebnisse der Arbeiten an photoaktivem Halbleitermaterial auf CuInS₂-Basis zielt die Erfindung darauf ab, Solarzellen mit entsprechenden Arbeitselektroden zu schaffen, die während der Oberflächenmodifizierung des Halbleitermaterials die Funktion von Photoanoden einnehmen. Weiterhin sollen sowohl für photoelektrochemische als auch für Festkörper-Solarzellen jeweils spezifische Einzelheiten aufgezeigt werden, die mit derartigen Photoanoden zu dem gewünschten hohen Wirkungsgrad führen. Außerdem besteht auch noch eine Aufgabe darin, anzugeben, welche Maßnahmen hauptsächlich zu ergreifen sind, um derartige Solarzellen herstellen bzw. das für die Photoanoden einzusetzende Halbleitermaterial synthetisieren zu können.

Zur erfindungsgemäßen Lösung sowie zu deren bevorzugten Ausgestaltungen führen insbesondere die nachfolgend genannten Eigenschaften, Mittel oder Maßnahmen:
- Im CuInS₂-Halbleitermaterial sollen als Fremdphasen In₂S₃, In und/oder Cu₂₋ₓS mit 0 ≦ x ≦ 1 in einer Konzentration zwischen jeweils 5 ^{o}/oo und 5 % enthalten sein; die Energielücke soll um 1,5 eV liegen;
- für eine Photoanode aus derartigem Halbleitermaterial ist eine Oberflächenmodifizierung einer aus dem Halbleitermaterial bestehenden Schicht, erzeugt insbesondere durch Polieren und/oder Ätzen, von erheblicher Bedeutung;
- bei einer photoelektrochemischen Solarzelle kann die Arbeitselektrode bevorzugt einen niederohmigen Rückkontakt aufweisen, der sich mittels einer In-Ga-Legierung, insbesondere mit einem Mischungsverhältnis von 90 : 10 Mol %, und eines Zweikomponenten-Leitsilbers zwischen dem als eine ca. 0,2 mm dicke Schicht vorliegenden Halbleitermaterial und einer Messinghalterung bilden und zwecks elektrischer Isolierung mit einem Silikonkautschuk verkleiden läßt;
- als Elektrolytflüssigkeit kommt hauptsächlich eine wäßrige Lösung von 1 M CaJ₂, 50 mM J₂ und 2,5 M HJ in Betracht;
- für eine Festkörper-Solarzelle mit einem Rückkontakt sollte unbedingt eine Oberflächenbehandlung der Halbleiterschicht erfolgen, beispielsweise eine elektro-chemische Behandlung zur Modifizierung der Oberfläche; als Frontkontakt ist sodann Au und/oder Cr lichtdurchlässig als Film, Gitter oder dgl. vorzusehen;
- die Dicke eines derartigen Metallfilmes für den Frontkontakt kann ca. 2 nm (= 20 Å) , maximal 20 nm (= 200 Å) betragen;
- in jedem Falle wirkt sich eine Antireflexionsschicht auf einem derartigen Frontkontakt, der als Metallfilm die Halbleiterschicht ganzflächig bedeckt, vorteilhaft aus;
- der Ausbildung des Rückkontaktes einer derartigen Festkörper-Solarzelle kommt im Hinblick auf die Modifizierung der Oberfläche der Photoanode besondere Wichtigkeit zu:
- der Rückkontakt sollte z.B. mittels einer In-Ga-Legierung, insbesondere mit einem Mischungsverhältnis von 77 : 23 Mol %, und eines Zweikomponenten-Leitsilbers zwischen der oberflächenmodifizierten Halbleiterschicht und einer Messinghalterung gebildet und zwecks elektrischer Isolierung mit einem Silikonkautschuk verkleidet sein.

Bei einer Ausbildung einer erfindungsgemäßen photoelektrochemischen Solarzelle kann hinsichtlich konstruktiver Maßnahmen weitgehend auf Einzelheiten zurückgegriffen werden, die der bereits eingangs erwähnten EP - A- 0 136 967 zu entnehmen sind.

Zur Herstellung einer erfindungsgemäßen Festkörper-Solarzelle wird vorgeschlagen, daß
zunächst
- der niederohmige Rückkontakt an der Halbleiterschicht, dessen synthetisiertes Material Einschlüsse von Fremdphasen, In₂S₃, In und/oder Cu₂₋ₓS mit 0 ≦ x ≦ 1 in einer Konzentration zwischen jeweils 5 ^{o}/oo und 5 %, enthält, und dessen Energielücke um 1,5 eV liegt, angebracht wird
und sodann
- die Oberflächenmodifizierung der Halbleiterschicht an ihrer dem Lichtstrom zugewandten Fläche in einer elektrochemischen Solarzelle erzeugt wird, wobei die Elektrolytlösung 2,5 M CaJ₂, 50 mM J₂ und 2 M HJ enthält, eine zyklische Polarisierung für einen Zeitraum von 1 Stunde im Potentialbereich von 0 V bis -0,4 V gegen Kalomel mit einer Geschwindigkeit von 20 mV/s durchgeführt und während dieser Behandlung die Oberfläche der Halbleiterschicht mit einer Beleuchtungsstärke von ca. 250 mW/cm² belichtet wird,
- nach dieser Oberflächenmodifizierung die am Rückkontakt angebrachte Halbleiterschicht aus der Elektrolytlösung entfernt und durch Anblasen mit Stickstoff getrocknet wird,
und schließlich
- der den Frontkontakt bildende Metallfilm mit einer Dicke von maximal 20 nm (200 Å) thermisch aufgedampft und mittels eines Zweikomponentenleitsilbers mit einem Anschlußdraht verbunden wird.

Zur Herstellung von Solarzellen gemäß der Erfindung wird außerdem ein besonders hierzu entwickeltes Verfahren vorgeschlagen. Das auf eine solche Weise synthetisierte Halbleitermaterial eignet sich sowohl für den Einsatz in photoelektrochemischen als auch bei Festkörper-Solarzellen. Die Maßnahmen diese Herstellungsverfahrens bestehen darin, daß zur Synthese des Halbleitermaterials auf der Basis des CuInS₂-Materialsystems mit einer um 1,5 eV liegenden Energielücke in einem abgeschlossenen, als Endvakuum 1,33 x 0⁻³ Pa (10⁻⁵ Torr) aufweisenden Behälter einerseits:
- Cu und In als Legierung an einem Ende des Behälters plaziert werden,
- die Cu-In-Legierung innerhalb etwa 1 Stunde auf 700 °C erwärmt und die Legierung erschmolzen wird,
- sodann eine weitere Erwärmung der Metallschmelze auf 1200 °C mit etwa 250 °C pro Stunde erfolgt,
andererseits:
- S an einem anderen Ende des Behälters plaziert und
- mit einer mittleren Geschwindigkeit von 150 °C pro Stunde bis auf 500 °C erwärmt und dadurch in die Gasphase überführt wird,
und sodann:
- im Verlauf von ca. 3 Stunden, in denen die Temperatur der Metallschmelze auf 1200 °C und der Schwefel durch gegebenenfalls geringfügige Temperaturerhöhung über 500 °C in der Gasphase gehalten werden, in der Cu-In-Schmelze das Wachstum von CuInS₂-Kristallen oder -Kristalliten mit dort enthaltenen Einschlüssen von Fremdphasen, In₂S₃, In und/oder Cu₂₋ₓS mit 0 ≦ x ≦ 1 in einer Konzentration zwischen jeweils 5 ^{o}/oo und 5 %, herbeigeführt wird, wobei in einem Zwischenbereich des Behälters bereits ab ca. 700 °C abdampfendes In und Teile des in der Gasphase befindlichen S zu In₂S₃ reagieren, welches sich als Nebenprodukt an der Behälterwand niederschlägt,
und danach
- die Abkühlung auf Raumtemperatur in ca. 6 Stunden vorgenommen wird.

In Weiterbildung dieser Maßnahmen kann insbesondere vorgesehen werden, daß
- die Ausgangsstoffe Cu : In : S im Molverhältnis 1 : 1 : 2 eingesetzt werden;
- das synthetisierte Halbleitermaterial einer thermischen Nachbehandlung für die Dauer von ca. 2 Minuten in einem H₂/Ar-Gasstrom, mit einem Mischungsverhältnis in Volumenanteilen von 2 : 10, bei bis zu 450 °C unterworfen wird;
- eine Reinigung der Ausgangssubstanzen durchgeführt wird, und zwar:
   - die Reduktion von In bei 800 °C in einem H₂/Ar-Gasstrom, mit einem Mischungsverhältnis der Volumenanteile von 1 : 10, innerhalb von etwa 3 Stunden;
   - die Reduktion von Cu bei 1100 °C in einem H₂/Ar-Gasstrom, mit einem Mischungsverhältnis der Volumenanteile von 1 : 10, innerhalb von etwa 2 Stunden;
   - die Reduktion und Homogenisierung der im Molverhältnis von 1 : 1 eingesetzten und legierten Cu-In-Mischung bei 800 °C in einem H₂/Ar-Gasstrom, mit einem Mischungsverhältnis der Volumenanteile von 1 : 10, innerhalb etwa 1 Stunde;
und
- die zu den Reduktionsprozessen eingesetzten Gasgemische durch eine Kühlfalle geleitet und dort bei ca. - 70 °C getrocknet werden.

Für die erfindungsgemäße technische Lehre ist also die Synthese des Halbleitermaterials mit dort enthaltenen Einschlüssen von Fremdphasen von wesentlicher Bedeutung. Bislang gewonnene Erkenntnisse lassen darauf schließen, daß es bei der Synthese insbesondere darauf ankommt, daß sich In₂S₃ bildet, und zwar außerhalb des Endprodukts mit einem Gesamtanteil von etwa 0,1 % der Indium-Einwaage. Jedenfalls wiesen Proben, bei deren Synthese dieser Effekt auftrat, hervorragende spektrale Eigenschaften sowie einen oben bereits erwähnten hohen Wirkungsgrad bei der Umwandlung von Sonnenenergie in Elektrizität in einem photoelektrochemischen Testgerät auf. Da beim Wachstum der Kristalle und Kristallite im Endprodukt auch Indiumeinschlüsse sowie Cu₂₋ₓS-Phasen mit 0 ≦ x ≦ 1 beobachtet werden konnten, wobei die Konzentrationsbereiche dieser Fremdphasen, einschließlich In₂S₃ im CuInS₂ jeweils zwischen 5 ^{o}/oo und 5 ^{o}/o lagen, sind auch diese Anteile sicherlich von ausschlaggebender Bedeutung für die Zwecke, auf die die Erfindung gerichtet ist.

Für die Erzeugung dieses Halbleitermaterials kommen auch zweifellos herkömmliche Methoden, insbesondere Sputtertechniken, Elektronenstrahlverdampfung, Gasphasentransport oder dergleichen in Betracht. Als besonders wirkungsvoll hat sich jedoch das oben angegelene Verfahren herausgestellt. Da für viele Anwendungsfälle das Halbleitermaterial als dünne Schicht benötigt wird, können die herkömmlichen Prozesse allerdings insoweit vorteilhaft sein, als dann die Herstellung von Plättchen oder Scheiben aus Blöcken entfallen kann.

Wie bereits erwähnt, kann bezüglich des konstruktiven Aufbaus einer photoelektrochemischen Solarzelle weitgehend auf Einzelheiten verwiesen werden, die in der eingangs genannten EP - A - 0 136 967 dargestellt und beschrieben sind. Weitere Details werden weiter unten im Zusammenhang mit den Erläuterungen zu den in der Zeichnung dargestellten Ausführungsformen beschrieben.

Überraschend hat sich gezeigt, daß das neuartige Halbleitermaterial auf der Basis von CuInS₂ mit Fremdphasen unter bestimmten Voraussetzungen auch für Festkörpersolarzellen geeignet ist. Diese Voraussetzungen lassen sich durch die oben in diesem Zusammenhang genannten Maßnahmen erfüllen.

Von besonderer, für derartige Ausführungsformen der Erfindung wesentlicher Bedeutung ist dabei, daß als Frontkontakt besondere Metalle, also elektrisch hoch leitendes Material, zur Anwendung kommen. Damit wird die Höhe der Kontaktspannung gegenüber dem Halbleitermaterial bestimmt, welches im vorliegenden Fall n-leitend ist. Danach wäre an sich zu vermuten, daß hohes Kontaktpotential infolge der niedrigen Austrittsarbeit beim Halbleitermaterial mit einem Metall zu erzielen ist, das eine hohe Austrittsarbeit besitzt, also beispielsweise mit Aluminium, Chrom, Kupfer, Gold, Nickel in dieser Reihenfolge. Kupfer und Nickel haben sich jedoch als weniger wirksam herausgestellt als Gold und Chrom. Hierfür konnte eine einleuchtende Erklärung bisher nicht gefunden werden.

Bei diesen Ausführungsformen der Erfindung muß der metallische Frontkontakt lichtdurchlässig sein. Dies kann bei flächendeckenden Metall-Filmen durch deren geringe Dicke, aber auch durch eine gitterartige Ausbildung der Metallisierung, dabei zweckmäßig in Verbindung mit einem Zwischenfilm aus transparentem, elektrisch leitendem Material zwischen dem Metallgitter und dem Halbleitermaterial erreicht werden. Der zweifellos nachteiligen Absorption des eingestrahlten Lichts, bei einem flächendeckenden Metallfilm sind die Vorzüge gegenüberzustellen, die mit dessen wesentlich einfacherer Herstellung im Vergleich zu SIS-Strukturen mit darüberliegendem Metallgitter verbunden sind. Gegebenenfalls kann die als flächendeckender Film ausgebildete Metallschicht noch mit einer Antireflexionsschicht versehen sein, um unumgängliche Verluste im wesentlichen auf die Absorption zu beschränken und nicht noch durch vermeidbare Reflexion zu erhöhen.

Für die Umwandlung von Solarenergie in elektrische Energie wird also mit der vorliegenden Erfindung auch eine einfach herstellbare und leicht zu handhabende Festkörper-Solarzelle zur Verfügung gestellt, wobei der metallische Frontkontakt maßgeblich für die Ausbildung einer Schottkykontakt-Struktur mit großer Potentialbarriere und effizienter Ladungssammlung ist. Die optischen Eigenschaften des CuInS₂-Halbleitermaterials und dessen Energielücke um 1,5 eV bieten bezüglich der Solarenergieumwandlung ohnehin schon von der Theorie her optimale Voraussetzungen.

In den Zeichnungen sind Ausführungsformen der Erfindung schematisch dargestellt und zur näheren Erläuterung des Wirkungsgrades Meßergebnisse angegeben. Es zeigen:
- Fig. 1:: die schematische Darstellung einer Syntheseapparatur mit Schaubildern für die Temperaturverläufe an den beiden Enden des Behälters,
- Fig. 2:: den Verlauf von Photostrom über der Lichtwellenlänge für erfindungsgemäß synthetisiertes CuInS₂-Halbleiter-Material,
- Fig. 3 und 4:: eine photoelektrochemische Solarzelle mit einer Arbeitselektrode aus erfindungsgemäßem Halbleitermaterial
- Fig. 5:: den Verlauf des Photostromes über der Photospannung bei einer Wirkungsgradmessung in einer Solarzelle gemäß Fig. 3/4,
- Fig. 6:: eine Festkörper-Solarzelle gemäß der Erfindung im Schnitt,
- Fig. 7:: den Photostrom/Photospannungs-Verlauf bei einer Festkörper-Solarzelle gemäß der Erfindung
- und Fig. 8:: ein Schaubild für die Transmission in Gold, 20 nm (200 Å) dick, in Abhängigkeit von der Wellenlänge.

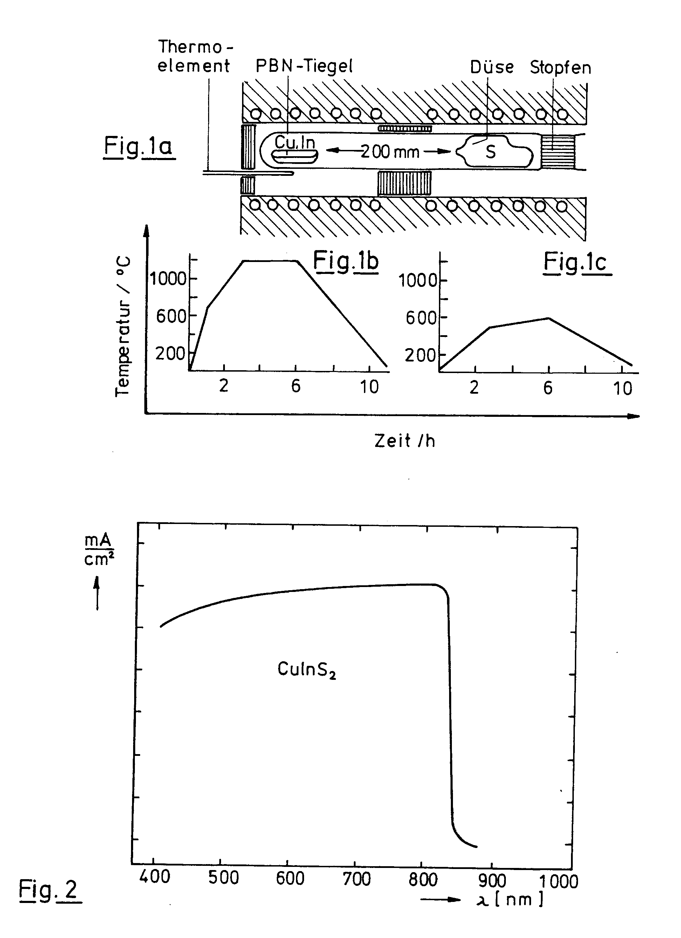

Die in Fig. 1 gezeigte Syntheseapparatur läßt einen horizontal in einem Ofen angeordneten Kolben erkennen, der mit einem Stopfen verschlossen ist. Es handelt sich dabei um eine Quarzampulle mit der Länge 1 = 300 mm und einem Durchmesser d = 22 mm. Der Ofen ist vorzugsweise mit zwei voneinander getrennt zu betreibenden Heizvorrichtungen ausgestattet. Die dort eingestellten Temperaturen können mittels Thermoelementen überwacht werden, von denen eines dargestellt ist. Es genügt jedoch, im Labormaßstab nur eine Heizung und eine Manschette vorzusehen, die die beiden Enden des Kolbens thermisch voneinander isoliert, sowie das Ende des Kolbens, an dem niedrigere Temperaturen herrschen als am anderen Ende, mit einem Kühlmittel anzublasen oder zu besprühen.

An dem Ende des Kolbens, an dem die höheren Temperaturen herrschen sollen, wird Kupfer - Cu - und Indium - In - als Legierung in einem Tiegel oder Boot aus pyrolytischem Bornitrid (PBN) plaziert. Der Schwefel - S - wird an anderan Ende des Kolbens in einem Vorratsgefäß mit feiner Düse deponiert.

Die Temperaturverläufe an beiden Enden des Kolbens sind in Abhängigkeit von der Zeit in den beiden Schaubildern angegeben. Nachdem die Cu-In-Legierung erschmolzen und der Schwefel in die Gasphase überführt ist, finden die gewünschten Reaktionen statt, d.h. im Metallschmelze-Tiegel wachsen CuInS₂-Kristalle bzw. Kristallite mit Einschlüssen von In, Cu₂₋ₓS mit 0 ≦ x ≦ 1 und In₂S₃. Im mittleren Bereich des Kolbens entsteht ebenfalls In₂S₃ - bereits bei einer Temperatur von 700 °C der Cu-In-Legierung bzw. Schmelze dampft In ab und reagiert mit einem Teil des in der Gasphase befindlichen Schwefels - und schlägt sich an der Behälterwandung nieder. Aus der Masse dieses außerhalb des Halbleiterbarrens anfallenden In₂S₃ lassen sich schon Rückschlüsse auf die Materialzusammensetzung im Barren ziehen. Der Halbleiterbarren hat eine Länge von ca. 100 mm und einen Durchmesser von ca. 10 mm.

Die Fig. 2 zeigt die Abhängigkeit des Photostromes in willkürlichen Einheiten von der Lichtwellenlänge für das auf diese Weise hergestellte photoaktive Halbleitermaterial. Der Photostrom ist über den Bereich des sichtbaren Lichts sehr hoch und nahezu konstant. Diese spektralen Eigenschaften sind insbesondere für Solarzellen als hervorragend zu beurteilen.

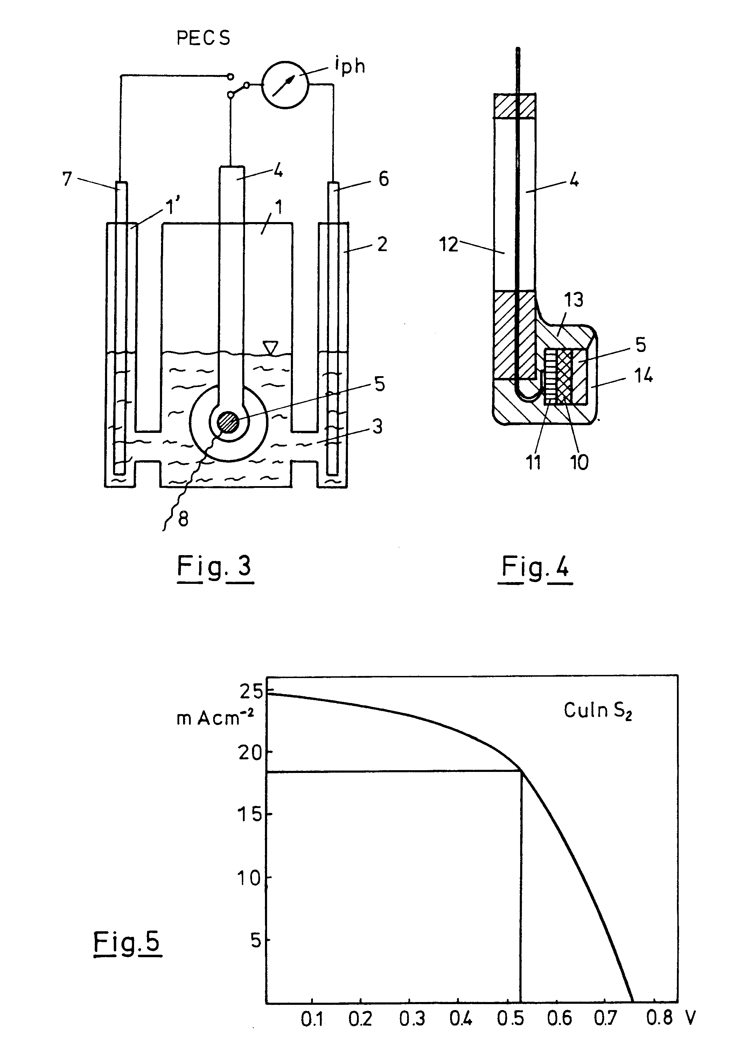

Die in Fig. 3 dargestellte photoelektrochemische Solarzelle PECS besitzt eine Kammer 1, in der sich die Arbeitselektrode 4 befindet, eine Nebenkammer 1' mit einer Referenzelektrode 7, die für wissenschaftliche Untersuchungen des Umwandlungsvorganges dient, aber für die Funktion der Solarzelle PECS als Wandler von Lichtenergie in elektrische Energie nicht erforderlich ist, und eine Kammer 2 mit der Gegenelektrode 6. Die Gegenelektrode 6 und auch die Referenzelektrode 7 bestehen z.B. aus einem Kohlenstoffstab. In den Kammern 1, 1', 2 befindet sich die Elektrolytlösung 3, die die Elektroden 4, 6, 7 zumindest teilweise benetzt. Am benetzten Ende der Arbeitselektrode 4 ist ein Halbleiterplättchen 5 angebracht, das von einem Lichtstrom 8 bestrahlt wird.

In Fig. 4 ist der Aufbau einer Arbeitselektrode 4 mit der Kontaktierung des Halbleiterplättchens 5 im Querschnitt dargestellt. Zwischen der Rückseite des Halbleiterplättchens 5 und dem Anschlußdraht 12 sind eine Schicht 10 aus In-Ga Amalgam und eine Ag-Kunstharz-Schicht 11 aufgebracht. Der Anschlußdraht 12 ist an oder in der Kunstharzschicht 11, befestigt und wird, elektrisch isoliert und korrosionsbeständig abgeschlossen, nach außen geführt. Das komplett kontaktierte Halbleiterplättchen 5 der Arbeitselektrode ist, ebenfalls elektrisch isolierend und korrosionsbeständig eingeschlossen, von einer geeigneten Masse 13, z.B. Epoxy-Harz, Glas oder einem Silikon-Kautschuk, umschlossen. Die Oberfläche des Halbleiterplättchens 5 muß mit der Elektrolytflüssigkeit unmittelbar in Kontakt kommen; beim Einhüllen, Einschmelzen oder dgl. mit der Masse 13 ist also darauf zu achten, daß eine Fensteröffnung 14 offen bleibt.

Dieser Aufbau stimmt im wesentlichen überein mit dem, der in der EP - A - 0 136 967 Fig. 1 und 2, dargestellt und beschrieben ist. Als Besonderheit ist im vorliegenden Fall die hier geänderte Herstellung des Rückkontaktes zu erwähnen. Eine In-Ga-Legierung (Mischungsverhältnis 90 : 10 Mol %) bildet die Schicht 10; die ca. 0,2 mm dicken Kristallplättchen sind mit einem Zweikomponenten-Leitsilber versehen (Fa. 3 M, A-B) und auf einen vorpolierten Messinghalter geklebt. Zwecks elektrischer Isolierung ist die Messinghülse mit Silikonkautschuk (Fa. Wacker Nr. A 33) verkleidet.

Fig. 5 zeigt den Verlauf des Photostromes über der Photospannung, gemessen zur Bestimmung des Wirkungsgrades bei der Umwandlung von Sonnenenergie in Elektrizität. Die Elektrodenfläche betrug 1,5 mm². Bei einer Lichtintensität von 85 mWcm⁻² unter AM 1-Bedingungen, eingestellt an einem kommerziellen Sonnensimulator (Fa. Oriel Corp.), lag der Wirkungsgrad bei 11,3 %. Die Lichtintensität wurde mit zwei Pyranometern (Fa. Polytec, Fa.Kipp-Zonen) gemessen und ergab identische Werte.

Als Elektrolyt wurde eine wäßrige Lösung von 1 M CaJ₂, 50 mM J₂, 2,5 M HJ verwendet. Die Lösung wurde nicht gerührt und an Luft gehalten. Der Abstand der Elektrode zum Fenster der Zelle betrug ca. 1 mm.

Die Ausbildung des Rückkontaktes ist, unabhängig vom speziellen Verwendungszweck, für die elektrischen Eigenschaften einer Elektrode mit einem Licht empfangenden Halbleitermaterial von nicht zu unterschätzender Bedeutung. Hierdurch, wie übrigens auch durch Oberflächenbehandlung der Licht empfangenden Elektrodenfläche, läßt sich der Wirkungsgrad insbesondere für die Umwandlung von Sonnenenergie in Elektrizität, maßgeblich beeinflussen.

Bezüglich der Materialzusammensetzung des Halbleitermaterials gemäß der Erfindung ist übrigens im Hinblick auf die Synthese darauf zu achten, daß keine unerwünschten Materialeinschlüsse entstehen. Dies wäre z.B. der Fall, wenn Cu-In-Gemische direkt mit Quarzglas in Berührung kommen. Ein Schiffchen oder ein Substrat z.B. aus pyrolytischem Bornitrid (PBN) für das Cu-In-Gemisch verhindert derartige Auswirkungen.

Das als Neben- bzw. sogar als Abfallprodukt zu bezeichnende und sich außerhalb des synthetisierten Halbleitermaterials bildende In₂S₃ läßt auf einfache Weise zu, Rückschlüsse auf die gewünschte Synthese zu ziehen, so daß auch hiermit ein Vorteil für die Erfindung verbunden ist.

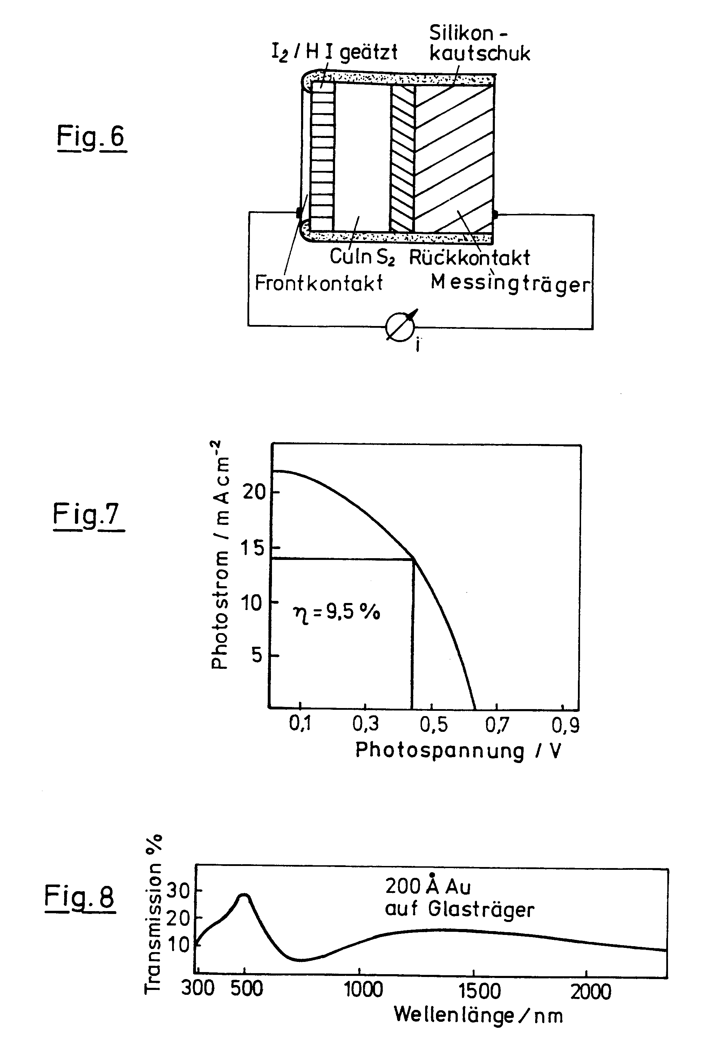

Die Herstellung des Frontkontaktes für eine Festkörper-Solarzelle gemäß Fig. 6 erfolgt in der Weise, daß eine entsprechend den oben erwähnten Angaben montierte Elektrode zunächst in einer elektrochemischen Solarzelle, bestehend aus einer Arbeitselektrode (CuInS₂), Gegenelektrode (Kohlestab) und Referenzelektrode (Kalomelelektrode), die untereinander durch einen Leitelektrolyten, bestehend aus 2,5 M CaJ₂, 50 mM J₂ und 2 M HJ, elektrisch verbunden sind, für einen Zeitraum von 1 h im Potentialbereich von 0 V bis -0,4 V gegen Kalomel mit einer Geschwindigkeit von 20 mV/s zyklisch polarisiert wird. Während dieser Behandlung wird die Elektrodenoberfläche mit einer Beleuchtungsstärke von ca. 250 mW/cm² beleuchtet. Die Lösung wird an Luft gehalten und nicht gerührt. Der Abstand der Elektrodenoberfläche zum Fenster der Zelle beträgt ca. 1 mm.

Nach dieser Behandlung zur Oberflächenmodifikation wird die Elektrode aus der Lösung entfernt und die Elektrodenoberfläche ohne jede weitere Behandlung durch Anblasen mit Stickstoffgas getrocknet. Danach wird die Elektrode unverzüglich, d.h. in einem Zeitraum von weniger als 60 s, in einem Vakuumsystem deponiert und montiert und das System evakuiert. Bei einem Druck von weniger als 133,3 x 10⁻³ Pa (10⁻³ Torr) wird ein 20 mm (200 Å) dicker Goldfilm thermisch auf die Probe gedampft. Mit einer solchen Probe wurde bei den Arbeiten an der Erfindung zugleich ein Glasträger im gleichen Abstand von derselben Verdampfungsquelle zu Vergleichszwecken bedampft.

Die auf diese Weise hergestellte Festkörper-Solarzelle ist dann noch an einer Stelle der Elektrodenoberfläche durch Silberepoxydharz (Fa. 3 M, A-B) leitend mit einem Cu-Draht zu verbinden, wie in Fig. 6 dargestellt ist.

Messungen zur Ermittlung des Wirkungsgrades bei Sonnenenergieumwandlung wurden so ausgeführt, daß die zu beleuchtende Elektrodenoberfläche zur Sonne ausgerichtet wurde, bis der Photostrom sein Maximum zeigte. Der Frontkontakt wurde über eine Widerstandskaskade und ein Strommeßgerät mit dem Rückkontakt verbunden. Der jeweilige Photostromwert bei eingestelltem Widerstand wurde gemessen und die Spannung nach dem Ohmschen Gesetz ermittelt. Das Ergebnis für eine 1,46 mm² große Elektrodenoberfläche bei Belichtung zeigt Fig. 7. Die Beleuchtungsstärke betrug dabei 64 mW/cm² und wurde mit einem Pyranometer (Fa. Kipp-Zonen) gemessen.

In der in Fig. 7 dargestellten Meßkurve ist die Absorption des Goldfilms durch einen multiplikativen Faktor von 6,5 bezüglich der Beleuchtungsstärke berücksichtigt. Dieser Faktor wurde bestimmt, indem die Beleuchtungsstärke der Sonne durch die als Fenster dienende mitbedampfte Glasplatte gemessen (12,3 mW/cm²) und mit dem Wert ohne Benutzung des Fensters (81,1 mW/cm²) verglichen wurde. Die Transmission dieses Goldfilms ist in Fig. 8 wiedergegeben und zeigt im Bereich des Sonnenlichtspektrums Werte zwischen etwa 10 % und 30 %.

Die gleichen Resultate ergaben sich mit einem 20 nm (200 Å) dicken Cr-Frontkontakt, der nach demselben Verfahren auf die Probenoberfläche aufgebracht wurde.

## Patentansprüche

1. Solarzelle mit einem Halbleitermaterial auf der Basis des CuInS₂-Materialsystems,
**gekennzeichnet durch**
synthetisiertes Halbleitermaterial, das als Einschlüsse von Fremdphasen In₂S₃, In und/oder Cu₂₋ₓS mit 0 ≦ x ≦ 1 in einer Konzentration zwischen jeweils 5 ^{o}/oo und 5 % enthält, und dessen Energielücke um 1,5 eV liegt.

2. Solarzelle nach Anspruch 1,
**gekennzeichnet durch**
eine Photoanode, bei der eine Oberflächenmodifizierung einer aus dem Halbleitermaterial bestehenden Schicht insbesondere durch Polieren und/oder Ätzen erzeugt wurde.

3. Solarzelle nach Anspruch 1 oder 2,
**gekennzeichnet durch**
eine Ausbildung als photoelektrochemische Solarzelle, deren Arbeitselektrode einen niederohmigen Rückkontakt aufweist, der mittels einer In-Ga-Legierung, insbesondere mit einem Mischungsverhältnis von 90 : 10 Mol %, und eines Zweikomponenten-Leitsilbers zwischen dem als eine ca. 0,2 mm dicke Schicht vorliegenden Halbleitermaterial und einer Messinghalterung gebildet und zwecks elektrischer Isolierung mit einem Silikonkautschuk verkleidet ist.

4. Solarzelle nach Anspruch 3,
**gekennzeichnet durch**
eine wäßrige Lösung von 1 M CaJ₂, 50 mM J₂ und 2,5 M HJ als Elektrolytflüssigkeit.

5. Solarzelle nach Anspruch 2,
**gekennzeichnet durch**
eine Ausbildung als Festkörper-Solarzelle mit einem Rückkontakt, einer durch elektro-chemische Behandlung oberflächenmodifizierten Halbleiterschicht und einem Frontkontakt aus Au und/oder Cr, der lichtdurchlässig als Film oder Gitter ausgebildet ist.

6. Solarzelle nach Anspruch 5,
**dadurch gekennzeichnet,** daß
der den Frontkontakt bildende Metallfilm eine Dicke von ca. 2 nm (20 Å), maximal 20 nm (200 Å) aufweist.

7. Solarzelle nach Anspruch 5 oder 6,
**dadurch gekennzeichnet,** daß
der den Frontkontakt bildende Metallfilm die Halbleiterschicht ganzflächig bedeckt und mit einer Antireflexionsschicht versehen ist.

8. Solarzelle nach einem der Ansprüche 5 bis 7,
**dadurch gekennzeichnet,** daß
der Rückkontakt mittels einer In-Ga-Legierung, insbesondere mit einem Mischungsverhältnis von 77 : 23 Mol %, und eines Zweikomponenten-Leitsilbers zwischen der oberflächenmodifizierten Halbleiterschicht und einer Messinghalterung gebildet und zwecks elektrischer Isolierung mit einem Silikonkautschuk verkleidet ist.

9. Solarzelle nach Anspruch 8,
**dadurch gekennzeichnet,** daß
die oberflächenmodifizierte Halbleiterschicht eine Dicke von ca. 0,2 mm aufweist.

10. Verfahren zur Herstellung einer Festkörper-Solarzelle gemäß einem der Ansprüche 5 bis 9,
**dadurch gekennzeichnet,** daß
zunächst
- der niederohmige Rückkontakt an der Halbleiterschicht, dessen synthetisiertes Material Einschlüsse von Fremdphasen, In₂S₃, In und/oder Cu₂₋ₓS mit 0 ≦ x ≦ 1 in einer Konzentration zwischen jeweils 5 ^{o}/oo und 5 %, enthält, und dessen Energielücke um 1,5 eV liegt, angebracht wird
und sodann
- die Oberflächenmodifizierung der Halbleiterschicht an ihrer dem Lichtstrom zugewandten Fläche in einer elektrochemischen Solarzelle erzeugt wird, wobei die Elektrolytlösung 2,5 M CaJ₂, 50 mM J₂ und 2 M HJ enthält, eine zyklische Polarisierung für einen Zeitraum von 1 Stunde im Potentialbereich von 0 V bis -0,4 V gegen Kalomel mit einer Geschwindigkeit von 20 mV/s durchgeführt und während dieser Behandlung die Oberfläche der Halbleiterschicht mit einer Beleuchtungsstärke von ca. 250 mW/cm² belichtet wird,
- nach dieser Oberflächenmodifizierung die am Rückkontakt angebrachte Halbleiterschicht aus der Elektrolytlösung entfernt und durch Anblasen mit Stickstoff getrocknet wird,
und schließlich
- der den Frontkontakt bildende Metallfilm mit einer Dicke von maximal 20 nm (200 Å) thermisch aufgedampft und mittels eines Zweikomponentenleitsilbers mit einem Anschlußdraht verbunden wird.

11. Verfahren zur Herstellung einer Solarzelle gemäß einem der Ansprüche 1 bis 9,
**dadurch gekennzeichnet,** daß
zur Synthese des Halbleitermaterials auf der Basis des CuInS₂-Materialsystems mit einer um 1,5 eV liegenden Energielücke in einem abgeschlossenen, als
Endvakuum 1,33 x 10⁻³ Pa (10⁻⁵ Torr) aufweisenden Behälter einerseits:
- Cu und In als Legierung an einem Ende des Behälters plaziert werden,
- die Cu-In-Legierung innerhalb etwa 1 Stunde auf 700 °C erwärmt und die Legierung erschmolzen wird,
- sodann eine weitere Erwärmung der Metallschmelze auf 1200 °C mit etwa 250 °C pro Stunde erfolgt,
andererseits:
- S an einem anderen Ende des Behälters plaziert und
- mit einer mittleren Geschwindigkeit von 150 °C pro Stunde bis auf 500 °C erwärmt und dadurch in die Gasphase überführt wird,
und sodann:
- im Verlauf von ca. 3 Stunden, in denen die Temperatur der Metallschmelze auf 1200 °C und der Schwefel durch gegebenenfalls geringfügige Temperaturerhöhung über 500 °C in der Gasphase gehalten werden, in der Cu-In-Schmelze das Wachstum von CuInS₂-Kristallen oder -Kristalliten mit dort enthaltenen Einschlüssen von Fremdphasen, In₂S₃, In und/oder Cu₂₋ₓS mit 0 ≦ x ≦ 1 in einer Konzentration zwischen jeweils 5 ^{o}/oo und 5 %, herbeigeführt wird, wobei in einem Zwischenbereich des Behälters bereits ab ca. 700 °C abdampfendes In und Teile des in der Gasphase befindlichen S zu In₂S₃ reagieren, welches sich als Nebenprodukt an der Behälterwand niederschlägt,
und danach
- die Abkühlung auf Raumtemperatur in ca. 6 Stunden vorgenommen wird.

12. Verfahren nach Anspruch 11,
**dadurch gekennzeichnet,** daß
die Ausgangsstoffe Cu : In : S im Molverhältnis 1 : 1 : 2 eingesetzt werden.

13. Verfahren nach Anspruch 11 oder 12,
**dadurch gekennzeichnet,** daß
das synthetisierte Halbleitermaterial einer thermischen Nachbehandlung für die Dauer von ca. 2 Minuten in einem H₂/Ar-Gasstrom, mit einem Mischungsverhältnis in Volumenanteilen von 2 : 10, bei bis zu 450 °C unterworfen wird.

14. Verfahren nach einem der Ansprüche 11 bis 13,
**dadurch gekennzeichnet,** daß
eine Reinigung der Ausgangssubstanzen durchgeführt wird, und zwar:
- die Reduktion von In bei 800 °C in einem H₂/Ar-Gasstrom, mit einem Mischungsverhältnis der Volumenanteile von 1 : 10, innerhalb von etwa 3 Stunden;
- die Reduktion von Cu bei 1100 °C in einem H₂/Ar-Gasstrom, mit einem Mischungsverhältnis der Volumenanteile von 1 : 10, innerhalb von etwa 2 Stunden;
- die Reduktion und Homogenisierung der im Molverhältnis von 1 : 1 eingesetzten und legierten Cu-In-Mischung bei 800 °C in einem H₂/Ar-Gasstrom, mit einem Mischungsverhältnis der Volumenanteile von 1 : 10, innerhalb etwa 1 Stunde.

15. Verfahren nach Anspruch 14,
**dadurch gekennzeichnet,** daß
die zu den Reduktionsprozessen eingesetzten Gasgemische durch eine Kühlfalle geleitet und dort bei ca. - 70 °C getrocknet werden.

## Claims

1. Solar cell having a semiconductor material based on the CuInS₂-material system, characterised by synthesized semiconductor material which contains inclusions of foreign phases In₂S₃, In and/or Cu₂₋ₓS with 0 ≦ x ≦ 1 in a concentration of between, in each case, 5 ^{°}/oo and 5 % and the energy gap of which lies around 1.5 eV.

2. Solar cell according to claim 1, characterised by a photoanode in which a surface modification of a layer consisting of the semiconductor material has been produced, in particular by polishing and/or etching.

3. Solar cell according to claim 1 or 2, characterised by a formation as a photoelectrochemical solar cell, the work electrode of which has a low-resistance back contact which is formed by means of an In-Ga-alloy, in particular with a mixture ratio of 90 : 10 mol %, and a two-component conducting silver between the semiconductor material, present as an approximately 0.2 mm thick layer, and a brass support and is cased with a silicone rubber for the purposes of electrical insulation.

4. Solar cell according to claim 3, characterised by an aqueous solution of 1 M CaI₂, 50 mM I₂ and 2.5 M HI as electrolyte fluid.

5. Solar cell according to claim 2, characterised by a formation as a solid-state solar cell with a back contact, a semiconductor layer surface-modified by electro-chemical treatment and a front contact consisting of Au and/or Cr, which is formed as a film or lattice in a manner permeable to light.

6. Solar cell according to claim 5, characterized in that the metal film forming the front contact has a thickness of approximately 2 nm (20 Å), maximally 20 nm (200 Å).

7. Solar cell according to claim 5 or 6, characterised in that the metal film forming the front contact covers the whole surface of the semiconductor layer and is provided with an anti-reflective layer.

8. Solar cell according to one of the claims 5 to 7, characterised in that the back contact is formed by means of an In-Ga-alloy, in particular with a mixture ratio of 77 : 23 mol %, and a two-component conducting silver between the surface-modified semiconductor layer and a brass support and is cased with a silicone rubber for the purposes of electrical insulation.

9. Solar cell according to claim 8, characterised in that the surface-modified semiconductor layer has a thickness of approximately 0.2 mm.

10. Method for producing a solid-state solar cell according to one of the claims 5 to 9, characterised in that in the first instance
- the low-resistance back contact is installed on the semiconductor layer, the synthesized material of which contains inclusions of foreign phases In₂S₃, In and/or Cu₂₋ₓS with 0 ≦ x ≦ 1 in a concentration of between, in each case, 5 °/oo and 5 % and the energy gap of which lies around 1.5 eV;
and then
- the surface-modification of the semiconductor layer is produced on its surface facing the light flux in an electrochemical solar cell, in which case the electrolyte solution contains 2.5 M CaI₂, 50 mM I₂ and 2 M HI, a cyclic polarization is carried out for a period of 1 hour in the potential range of 0 V to -0.4 V against calomel at a speed of 20 mV/s and during this treatment the surface of the semiconductor layer is exposed to light with an intensity of illumination of approximately 250 mW/cm²;
- after this surface-modification the semiconductor layer installed on the back contact is removed from the electrolyte solution and is dried by blowing nitrogen thereon;
and finally
- the metal film forming the front contact is thermally vapor-deposited thereon with a thickness of maximally 20 nm (200 Å) and is connected with a connecting wire by means of a two-component conducting silver.

11. Method for producing a solar cell according to one of the claims 1 to 9, characterized in that for the purpose of the synthesis of the semiconductor material based on the CuInS₂-material system with an energy gap lying around 1.5 eV in a closed container having as a final vacuum 1.33 x 10⁻³ Pa (10⁻⁵ Torr) on the one hand:
- Cu and In are placed as an alloy at one end of the container;
- the Cu-In-alloy is heated within approximately 1 hour to 700°C and the alloy is melted;
- then the molten metal is heated further to 1200°C at approximately 250°C per hour;
on the other hand:
- S is placed at another end of the container and
- heated at an average speed of 150°C per hour up to 500 °C and as a result transferred into the gas phase;
and then:
- in the course of approximately 3 hours, in which the temperature of the molten metal is kept at 1200°C and the sulphur is kept in the gas phase by, if applicable, a slight raising of the temperature above 500°C, in the Cu-In-melt the growth of CuInS₂-crystals or -crystallites is brought about with inclusions, contained there, of foreign phases, In₂S₃, In and/or Cu₂₋ₓS with 0 ≦ x ≦ 1 in a concentration of between, in each case, 5 °/oo and 5 %, in which case in an intermediate area of the container In, already evaporating from approximately 700 °C, and parts of the S in the gas phase react to give In₂S₃, which is deposited as a by-product on the container wall;
and subsequently
- cooling to room temperature is effected in approximately 6 hours.

12. Method according to claim 11, characterised in that the starting materials Cu : In : S are used in the molar ratio of 1 : 1 : 2.

13. Method according to claim 11 or 12, characterised in that the synthesized semiconductor material is subjected to a subsequent thermal treatment for the duration of approximately 2 minutes in an H₂/Ar-gas stream, with a mixture ratio in volume proportions of 2 : 10, at up to 450°C.

14. Method according to one of the claims 11 to 13, characterised in that a purification of the starting materials is carried out, that is:
- the reduction of In at 800°C in an H₂/Ar-gas stream, with a mixture ratio of the volume proportions of 1 : 10, within approximately 3 hours;
- the reduction of Cu at 1100°C in an H₂/Ar-gas stream, with a mixture ratio of the volume proportions of 1 : 10, within approximately 2 hours;
- the reduction and homogenization of the alloyed Cu-In-mixture, used in the molar ratio of 1 : 1, at 800°C in an H₂/Ar-gas stream, with a mixture ratio of the volume proportions of 1 : 10, within approximately 1 hour.

15. Method according to claim 14, characterised in that the gas mixtures used for the reduction processes are conducted through a cooling trap and dried there at approximately - 70°C.

## Revendications

1. Cellule solaire comprenant un matériau semi-conducteur sur base du système CuInS₂,
caractérisée par un matériau semi-conducteur de synthèse, qui contient, sous la forme d'inclusions de phases étrangères In₂S₃, In et/ou Cu₂₋ₓS avec 0 ≦ x ≦ 1, suivant une concentration chaque fois comprise entre 5 ^{o}/oo et 5 % et dont la bande interdite a une valeur d'environ 1,5 eV.

2. Cellule solaire suivant la revendication 1,
caractérisée par une photoanode dans laquelle est produite une modification de surface d'une couche constituée du matériau semi-conducteur, en particulier par polissage et/ou par attaque.

3. Cellule solaire suivant l'une des revendications 1 et 2,
caractérisée par une réalisation sous la forme d'une cellule solaire photo-électrochimique, dont l'électrode de travail présente un contact arrière à basse résistance, qui est formé au moyen d'un alliage de In-Ga, en particulier suivant un dosage de 90/10 mol %, et d'un argent conducteur à deux composantes entre la couche de matériau semi-conducteur existante d'environ 0,2 mm d'épaisseur et un support en laiton et qui est recouvert d'un caoutchouc au silicone pour isolation électrique.

4. Cellule solaire suivant la revendication 3,
caractérisée par une solution aqueuse de 1 M de CaJ₂_{,} 50 mM de J₂ et 2,5 M de HJ comme liquide électrolytique.

5. Cellule solaire suivant la revendication 2,
caractérisée par une réalisation sous forme d'une cellule solaire an tant que corps solide comprenant un contact arrière, une couche semi-conductrice, dont la surface est modifiée par un traitement électrochimique, et un contact frontal en Au et/ou en Cr, qui est réalisé sous la forme d'un film perméable à la lumière ou d'une grille.

6. Cellule solaire suivant la revendication 5,
caractérisée en ce que le film métallique formant le contact frontal présente une épaisseur d'approximativement 2 nm (20 Å), au plus de 20 nm (200 Å).

7. Cellule solaire suivant l'une des revendications 5 et 6,
caractérisée en ce que le film métallique formant le contact frontal recouvre sur toute sa surface la couche semi-sonductrice et en ce qu'il est pourvu d'une couche antiréfléchissante.

8. Cellule solaire suivant l'une quelconque des revendications 5 à 7,
caractérisée en ce que le contact arrière est réalisé au moyen d'un alliage de In - Ga, en particulier suivant un dosage de 77/23 mol %, et d'un argent conducteur à deux composantes entre la couche semi-conductrice de surface modifiée et un support en laiton et en ce qu'il est recouvert d'un caoutchouc au silicone pour isolation electrique.

9. Cellule solaire suivant la revendication 8,
caractérisée en ce que la couche semi-conductrice à surface modifiée présente une épaisseur d'approximativement 0,2 mm.

10. Procédé de fabrication d'une cellule solaire en corps solide suivant l'une quelconque des revendications 5 à 9,
caractérisé en ce que
tout d'abord
- le contact arrière à basse résistance est appliqué à la couche semi-conductrice dont la matériau de synthèse contient des occlusions de phases étrangères de In₂S₃, de In et/ou de Cu₂₋ₓS mit 0 ≦ x ≦ 1, à raison d'une concentration comprise entre 5 ^{o}/oo et 5 % et dont la bande interdite a une valeur d' environ 1,5 eV;
et ensuite
- en ce que la modification de surface de la couche semi-conductrice est réalisée à sa surface qui est tournée vers le courant photoélectrique dans une cellule solaire électrochimique, la solution d'électrolyte contenant 2,5 M de CaJ₂, 50 mM de J₂ et 2 M de HJ, en ce qu'une polarisation cyclique est effectuée pendant un intervalle de temps d' 1 heure dans la gamme de potentiel allant de 0 V à - 0,4 V par rapport au calomel à une vitesse de 20 mV/s et pendant ce traitement, la surface de la couche semi-conductrice est éclairée avec un pouvoir éclairant d'approximativement 250 mW/cm²;
- en ce qu'après cette modification de surface, la couche semi-conductrice appliquée au contact arrière est retirée de la solution d'électrolyte et séchée par soufflement d'azote;
et finalement
- en ce que le film métallique formant le contact frontal est déposé à partir de la phase vapeur thermiquement a une epaisseur de maximum 20 nm (200 Å) et relié à un fil de raccordement au moyen d'un argent conducteur à deux composantes.

11. Procédé de fabrication d'une cellule solaire suivant l'une quelconque des revendications 1 à 9,
caractérisé en ce que pour la synthèse du matériau semi-conducteur sur base du système CuInS₂ présentant une bande interdite ayant une valeur d'environ 1,5 eV dans un récipient fermé et présentant un vide limite de 1,33 x 10⁻³ Pa (10⁻⁵ Torr)
d'une part:
- du Cu et de l'In sous forme d'un alliage sont placés à une extrémité du récipient;
- l'alliage de Cu - In est chauffé à 700 °C en approximativement une heure et l'alliage est fondu;
- ensuite, un autre réchauffement du bain de fusion a lieu jusqu'à 1200 °C, à raison d'environ 250 °C par heure;
d'autre part:
- du S est placé à une autre extrémité du récipient et
- est réchauffé à une vitesse moyenne de 150 °C par heure jusqu'à 500 °C et est ainsi transféré dans la phase gazeuse;
et ensuite:
- au cours d'approximativement 3 heures pendant lesquelles la température du bain de fusion est maintenue à 1200 °C et le soufre est maintenu dans la phase gazeuse éventuellement par une légère augmentation de la température au-delà de 500 °C la croissance de cristaux ou de cristallites de CuInS₂ dans la masse fondue de Cu-In avec des occlusions de phases étrangères qui y sont contenues, de In₂S₃, de In et/ou de Cu₂₋ₓS, où 0 ≦ x ≦ 1 à raison d'une concentration qui est chaque fois comprise entre 5 ^{o}/oo und 5 % est provoqué, de l'In s'évaporant déjà à partir d'approximativement 700 °C et une partie du S se trouvant en phase gazeuse réagissant dans une zone intermédiaire du récipient pour former du In₂S₃, qui se dépose sous forme d'un produit secondaire sur la paroi du récipient, et après cela
- le refroidissement jusqu'à la température ambiante est effectué en approximativement 6 heures.

12. Procédé suivant la revendication 11,
caractérisé en en ce que les matériaux de départ Cu, In, S sont utilisés suivant un rapport molaire de 1/1/2.

13. Procédé suivant l'une des revendications 11 et 12,
caractérisé en ce que le matériau semi-conducteur de synthèse est soumis à un traitement thermique ultérieur d'une durée d'approximativement 2 minutes dans un courant gazeux de H₂/Ar, suivant un rapport de mélange en parts de volume de 2/10, à raison d'une température allant jusqu' à 450 °C.

14. Procédé suivant l'une quelconque des revendications 11 à 13,
caractérisé en ce qu'une purification des matériaux de départ est effectuée, et celà par:
- une réduction de In à 800 °C dans un courant gazeux de H₂/Ar à raison d'un rapport de mélange en parts de volume de 1/10, pendant approximativement 3 heures;
- une réduction de Cu à 1100 °C dans un courant gazeux de H₂/Ar à raison d'un rapport de mélange en parts de volume de 1/20, pendant approximativement 2 heures;
- une réduction et une homogénéisation du mélange allié de Cu-In mis en oeuvre suivant un rapport molaire de 1/1 à 800 °C dans un courant gazeux de H₂/Ar, suivant un rapport de mélange en parts de volume de 1/10, pendant approximativement 1 heure.

15. Procédé suivant la revendication 14,
caractérisé en ce que les mélanges gazeux mis en oeuvre pour les processus de réduction sont amenés par un piège de refroidissement et qu'ils y sont séchés à approximativement à - 70 °C.n
